# EUROPÄISCHE PATENTSCHRIFT

(11) **EP 3 220 413 B1**
(45) Veröffentlichungstag und Bekanntmachung des Hinweises auf die Patenterteilung: **26.01.2022**
(21) Anmeldenummer: 16160367.5
(22) Anmeldetag: 15.03.2016
(51) Int. Cl.: H01L 21/677

(54) **SERVICEEINRICHTUNG**
SERVICE DEVICE
INSTALLATION DE MAINTENANCE

(43) Veröffentlichungstag der Anmeldung: 20.09.2017
(73) Patentinhaber: Integrated Dynamics Engineering GmbH, 65479 Raunheim (DE)
(72) Erfinder: Birkner, Andreas, 07743 Jena (DE); Schadt, Simon, 65195 Wiesbaden (DE); Evers, Arndt, 65375 Oestrich-Winkel (DE)
(74) Vertreter: Blumbach · Zinngrebe Patentanwälte PartG mbB

(56) Entgegenhaltungen:
- JP-A- 2005 294 280
- US-A- 5 893 795
- US-A1- 2010 193 711
- US-A1- 2011 262 252
- US-A1- 2013 051 957

## Beschreibung

### Gebiet der Erfindung

Die Erfindung betrifft eine Serviceeinrichtung, welche zum Anheben und Bewegen von Bauteilen einer Anlage zur Prozessierung von Halbleiterbauelementen ausgebildet ist, insbesondere Teile einer Metrology-Anlage, einer Lithographie-Anlage oder Teile einer Prozessanlage. Mittels der Serviceeinrichtung sollen derartige Teile angehoben und horizontal verfahren werden können. Die Anlage soll insbesondere für die Verwendung in Reinräumen vorgesehen sein.

### Hintergrund der Erfindung

In der Halbleiterindustrie vergrößern sich mit den Substraten auch die Anlagen zur Prozessierung der Substrate, wie beispielsweise Lithographieanlagen, optische Inspektionsgeräte etc.

Es kann sich dabei beispielsweise um Teile des Substrathandlings, einer Lichtquelle einer Elektronenstrahlquelle oder eines Messsensors oder einer Kombination dieser Teile handeln. Zu Wartungszwecken ist es erforderlich, das jeweilige Anlagenteil abzuheben und seitlich zu bewegen, um an die darunterliegenden Geräte oder Komponenten zu kommen oder um das bewegte Teil selbst zu inspizieren.

Hierfür werden in der Praxis zumeist mobile Servicekräne verwendet. Diese sind in der Bedienung umständlich und es ist vielfach schwierig, an die betroffenen Anlagenteile heranzukommen. Insbesondere ist es oft notwendig, zunächst mehrere Anlagenteile wegzubewegen, um an ein darunterliegendes Anlagenteil zu kommen.

Dies führt zu entsprechend kostspieligen Standzeiten der Anlage. Weiterhin besteht das Risiko einer Verunreinigung oder Beschädigung der Anlage oder Teilen davon. Weiterhin sind je nach beispielsweise Gewicht, Form und Lage der Anlage und der zu bewegenden Anlagenteile Maßnahmen zur Gewährleistung der Sicherheit und der Einhaltung der Ergonomie für das die Arbeiten durchführende Servicepersonal zu ergreifen.

Die Offenlegungsschrift US 2013/0088702 A2 zeigt eine Hebeeinrichtung für das Modul eines Lithographiegerätes, welche in die Anlage integriert ist und so den Vorteil von kürzeren Servicezeiten nach sich ziehen soll. Nachteilig an dieser Anlage ist, dass diese wenig flexibel und integraler Bestandteil der Anlage ist, d.h. die in dem Dokument beschriebene Hebeeinrichtung wird individuell für eine konkrete Hebeaufgabe hergestellt und es ist nur schwierig möglich, eine derartige Anlage flexibel zum Heben verschiedener Anlagenteile zu verwenden.

Die Offenlegungsschrift US 2010/0193711 A1 beschreibt ein weiteres Beispiel einer Hebeeinrichtung für ein EUV-Lithographiegerät, mit dem Teile des Lithographiegerätes ausgetauscht werden können. Das Gerät umfasst hierzu zusätzlich eine Hebevorrichtung, die vorgesehen ist, um ein Bauteil aus der Kammer anzuheben und zu bewegen, so dass es ausgetauscht werden kann. Die Hebeeinrichtung ist dabei ebenfalls fest in die Anlage integriert.

### Aufgabe der Erfindung

Der Erfindung liegt demgegenüber die Aufgabe zugrunde, die genannten Nachteile des Standes der Technik zu reduzieren. Insbesondere soll eine Serviceeinrichtung bereitgestellt werden, mittels derer auch hohe Lasten bewegt werden können und welche ansonsten flexibel verwendet werden kann und welche einfach und kompakt ausgebildet ist.

Die Erfindung betrifft insbesondere eine Serviceeinrichtung, mit welcher Anlagenteile in kurzer Zeit, mit geringen Verunreinigungen für die Anlage, sicher und ergonomisch für das ausführende Personal, und sicher für die Anlage und die Anlagenteile bewegt werden können.

### Zusammenfassung der Erfindung

Die Aufgabe der Erfindung wird bereits durch eine Serviceeinrichtung nach Anspruch 1 gelöst.

Bevorzugte Ausführungsformen und Weiterbildungen der Erfindung sind dem Gegenstand der abhängigen Ansprüche, der Beschreibung sowie den Zeichnungen zu entnehmen.

Die Erfindung betrifft eine Serviceeinrichtung, welche zum Anheben und Bewegen von Bauteilen einer Anlage zur Prozessierung von Halbleiterbauelementen ausgebildet ist. Insbesondere ist die erfindungsgemäße Serviceeinrichtung reinraumtauglich.

Die Serviceeinrichtung ist ausgelegt, Gewichte von mindestens 5 kg, vorzugsweise mindestens 50 kg, besonders bevorzugt mindestens 500 kg, zu bewegen. Hierzu ist die Serviceeinrichtung als automatisiertes Werkzeug vorgesehen, welches permanent oder temporär in der Maschine oder Anlage integriert ist.

Die Serviceeinrichtung umfasst einen Träger sowie einen Arm mit einer Einrichtung zum Anheben eines Bauteils. Der Arm ist mittels eines Verbindungsstücks in einer horizontalen Ebene schwenkbar am Träger angeordnet, wobei das Verbindungsstück entlang des Trägers verfahrbar ist und wobei der Arm quer zum Träger in einer vertikalen Richtung verfahrbar ist.

Die Erfindung betrifft also einen von einem Träger in einer horizontalen Richtung wegklappbaren Arm, welcher insbesondere mittels eines Scharniers mit dem Träger verbunden ist.

Dieses Scharnier kann insbesondere Teil des Verbindungsstücks sein.

Es versteht sich, dass sich "horizontal" und "vertikal" auf die Orientierung der Komponenten der Serviceeinrichtung im aufgestellten Zustand bezieht.

Durch eine Schwenkbewegung kann der Arm von einer Seite her über eine Anlage und deren Komponenten bewegt werden.

Bei einer Ausführungsform erfolgt diese Schwenkbewegung manuell. Bei einer anderen Ausführungsform ist für die Schwenkbewegung ein Aktor, insbesondere ein Motor, vorgesehen.

Vorzugsweise ist die Schwenkbewegung gegenüber dem Träger um mindestens 90° möglich. Bei einer anderen Ausführungsform ist möglich, dass eine Schwenkbewegung von 180° erfolgt. So kann der Arm in zwei Orientierungen jeweils mit der gegenüberliegenden Seite an dem Träger angeordnet sein.

Ein beliebig ausgestaltetes Verbindungsstück ist horizontal entlang der Haupterstreckungsrichtung des Trägers verfahrbar. Dies kann beispielsweise mittels eines Linearmotors, eines Direktantriebs, eines Magnet- oder Luftlagers oder einer Gewindespindel realisiert werden.

Weiter ist der Arm quer zum Träger in einer vertikalen Richtung verfahrbar.

Dies kann insbesondere dadurch realisiert sein, dass das Verbindungsstück eine Armaufnahme für den Arm sowie eine Trägeraufnahme aufweist. Die Armaufnahme ist gegenüber der Trägeraufnahme linear in einer vertikalen Richtung verfahrbar. Dies kann ebenfalls mit den vorstehend genannten Komponenten wie beispielsweise einer Gewindespindel oder einem Linearantrieb realisiert werden.

Die vertikale Verfahrbarkeit dient dem Anheben des jeweiligen Anlagenteils mittels des Arms. Hierfür reicht in der Regel eine relativ geringe Hubhöhe aus, d.h. das Verbindungsstück, entlang dessen der Arm vertikal verfahren werden kann, ist kürzer als der Träger ausgebildet.

Arm und/oder Träger sind vorzugsweise als Schienen, insbesondere als Metallschienen, ausgebildet.

Bei einer alternativen Ausführungsform können Faserverbundwerkstoffe, wie Kohlefaserkomponenten, verwendet werden, um eine besonders leichte Ausgestaltung der Serviceeinrichtung zu ermöglichen.

Die Serviceeinrichtung weist des Weiteren eine Lastaufnahme für das Bauteil auf.

Unter einer Lastaufnahme wird ein Mittel verstanden, um das Bauteil, welches in dem oder aus dem Anlagenbereich heraus bewegt werden soll, zu fixieren und anheben zu können. Dies kann beispielsweise eine Verschraubung, ein Greifer oder eine Gabel sein.

Die erfindungsgemäße Serviceeinrichtung zieht zum einen eine hohe Flexibilität nach sich, insbesondere können bei entsprechender Dimensionierung von Träger und Arm nahezu sämtliche Komponenten einer Anlage bewegt werden.

Zum anderen kann die Serviceeinrichtung vorzugsweise zu einer mobilen Einheit zusammengeklappt werden. Weiterhin kann die Serviceeinrichtung in einer Ausführungsform so zusammengeklappt werden, dass sie installiert in einer Anlage möglichst wenig Platz beansprucht.

Insbesondere ist es möglich, eine Serviceeinrichtung bereitzustellen, mittels der hohe Lasten bewegt werden können, welche aber gleichzeitig von einer einzigen Person zur Anlage gebracht und aufgestellt werden kann.

Die Serviceeinrichtung kann, wie es bei einer Ausführungsform vorgesehen ist, einen Koffer, beispielsweise einen Rollkoffer, umfassen, wobei die zu einer mobilen Einheit zusammengeklappte Serviceeinrichtung in dem Koffer angeordnet ist und so mittels des Koffers zur Anlage bewegt werden kann.

Gemäß einer bevorzugten Ausführungsform der Erfindung ist der Arm und/oder die Lastaufnahme abnehmbar ausgebildet. So kann die Serviceeinrichtung leicht adaptiert werden, indem Arm und/oder Lastaufnahme ausgetauscht werden. Die Serviceeinrichtung lässt sich so anpassen, um unterschiedliche Bauteile anheben zu können.

Die Serviceeinrichtung ist vorzugsweise reinraumtauglich ausgebildet. Hierfür umfasst die Serviceeinrichtung gemäß einer Ausführungsform der Erfindung schmiermittelfreie Lager, Schienen und/oder Lager.

Neben schmiermittelfreien Bauteilen mit Gleitflächen können dies zum Beispiel Magnet- oder Luftlager sein.

Unter "schmiermittelfrei" wird der Verzicht auf flüssige, insbesondere fett- oder ölhaltige Aufträge verzichtet.

Gleitflächen weisen vorzugsweise eine Gleitbeschichtung auf. Neben Elastomermaterialien können dies auch Lager und Schienen mit einer Hartstoff-Beschichtung sein, insbesondere DLC (diamond like carbon).

Bei einer Weiterbildung der Erfindung umfasst der Arm zumindest zwei ausziehbare Segmente.

Diese lassen sich vorzugsweise teleskopartig zusammenschieben, wodurch ein weiter Aktionsradius bei gleichzeitig kleinem Bauraum in zusammengeklapptem Zustand ermöglicht wird.

Bei einer bevorzugten Ausführungsform der Erfindung ist der Arm über das Verbindungsstück rotierbar ausgebildet.

Hierunter wird verstanden, dass der Arm entlang einer horizontal verlaufenden Achse, welche senkrecht zum Träger angeordnet ist, gedreht werden kann.

Hierdurch kann zum einen ermöglicht werden, dass der Arm um 180° gedreht wird, um ein nur auf einer Seite vorhandenes Aufnahmemittel für ein Anlagenteil in die andere Richtung hin zu orientieren.

Zum anderen wird so ermöglicht, dass der Arm nicht nur horizontal über die Anlage geschwenkt wird, sondern dass dieser in eine nach unten oder oben verlaufende vertikale Richtung gebracht wird.

So ist es möglich, sehr schwere Anlagenteile, wie beispielsweise eine Granitplatte, mittels einer kompakt ausgestalteten Serviceeinrichtung zu bewegen, da in dieser vertikalen Position des Arms keine nennenswerten Hebelkräfte auf den Arm wirken.

Es ist insbesondere vorgesehen, zum Heben schwerer Lasten zwei sich gegenüberliegende Serviceeinrichtungen zu verwenden, welche von beiden Seiten an den Rand des betreffenden Bauteils ragen, ohne dass der Arm über das Bauteil hinweggeschwenkt sein muss.

Bei leichteren Anlagenkomponenten genügt hingegen eine einzige Serviceeinrichtung. Der Arm wird horizontal über der Anlage geschwenkt, um überall Bauteile erreichen zu können.

Um Anlagenteile abzuheben, kann die Lastaufnahme, wie es bei einer bevorzugten Ausführungsform vorgesehen ist, vorzugsweise ausklappbare Gabeln aufweisen. Die Gabeln sind mit dem Arm verbunden.

Bei einer Weiterbildung der Erfindung sind die Gabeln entlang des Arms verschiebbar. Die Gabeln können insbesondere dem Anheben von leichteren Anlagenteilen dienen. Vorzugsweise können auch die Gabeln drehbar am Arm angeordnet sein, so dass diese durch eine einfache Drehbewegung parallel zum Arm angeordnet und zusammengeklappt werden können, um wiederum ein kompakt ausgestaltetes Modul im zusammengeklappten Zustand zu ermöglichen.

Bei einer Weiterbildung der Erfindung weist der Arm eine weitere Aufnahme für ein Bauteil auf, welche vorzugsweise auf einer den Gabeln gegenüberliegenden Seite des Arms angeordnet ist.

Dabei kann es sich insbesondere um eine Auflage, wie beispielsweise um einen Winkel, handeln.

Vorzugsweise ist diese der Gabel gegenüberliegende Aufnahme zum Anheben von schwereren Lasten vorgesehen, insbesondere von Lasten, bei denen sich während des Anhebens die Arme in vertikaler Ausrichtung befinden.

Bei einer Weiterbildung der Erfindung kann die Serviceeinrichtung, insbesondere eine Bewegungskurve der Serviceeinrichtung, mittels eines Datums- oder eines Datensatzes programmiert werden, welcher anlagenseitig vorhanden ist.

Es ist insbesondere vorgesehen, anlagenseitig der jeweiligen Anlage eine individuelle Kennung zuzuteilen.

Dies kann im einfachsten Falle eine Nummer sein, welche manuell in einen Controller des Servicegeräts eingegeben wird.

Vorzugsweise ist das Servicegerät mit einem Lesegerät ausgestattet, mit dem es einen anlageseitig vorhandenen Datensatz einlesen kann. Dies kann beispielsweise in Form eines RFID-Systems oder in Form eines Barcodes realisiert sein.

So kann sich die Serviceeinrichtung beim Anbringen an einer Anlage anlagenspezifisch anpassen, etwa indem individuelle Bewegungsprofile aus einem Speicher geladen werden und abrufbar sind.

Die Erfindung betrifft des Weiteren eine Anlage, welche insbesondere zur Prozessierung von Halbleiterbauelementen ausgebildet ist.

Die Anlage umfasste eine Serviceeinrichtung, welche an der Anlage anbringbar ist. Insbesondere ist die Serviceeinrichtung in einem Rahmen der Anlage anbringbar.

Die Serviceeinrichtung weist des Weiteren Mittel zum Anheben eines Bauteils auf.

Unter einer Anbringbarkeit an der Anlage wird verstanden, dass die Serviceeinrichtung temporär mit der Anlage verbunden werden kann.

Im Unterschied zu bekannten Kränen ist die Serviceeinrichtung im verbundenen Zustand also Teil der Anlage, kann aber abgenommen werden, um so nur im Bedarfsfall montiert zu sein.

Die Kosten für die Bereitstellung einer derartigen Serviceeinrichtung werden so erheblich reduziert.

Weiter muss Ausrüstung, welche integraler Bestandteil der Anlage ist, zumeist nicht gesondert zertifiziert werden.

Die Anlage umfasst eine Serviceeinrichtung, welche vorzugsweise zumindest einen Träger und zumindest eine Lastaufnahme umfasst, mittels der ein Bauteil, welches sich im Anlagenbereich befindet, anhebbar ist.

Die Lastaufnahme ist derart ausgebildet, dass sie gegenüber dem Träger zumindest eine vertikal und eine horizontal verlaufende Bewegung ausführen kann.

Vorzugsweise ist die Serviceeinrichtung eine Serviceeinrichtung wie sie vorstehend beschrieben wurde.

Die Serviceeinrichtung wird, wie es bei einer bevorzugten Ausführungsform vorgesehen ist, mittels einer anlagenseitigen Aufnahme verbunden.

Es ist insbesondere vorgesehen, dass die Anlage einen Rahmen aufweist, an welchem der Träger befestigbar ist.

Dies kann insbesondere mittels eines Schnellspannmechanismus erfolgen.

Zum Heben von schwereren Bauteilen kann die Anlage zwei sich gegenüberliegende Serviceeinrichtungen umfassen.

Die Erfindung betrifft des Weiteren ein Verfahren zum Anheben und Bewegen eines Bauteils, insbesondere des Bauteils einer Anlage zur Prozessierung von Halbleiterbauelementen. Dabei wird eine Serviceeinrichtung oder eine Anlage nach einem der vorstehenden Ansprüche verwendet.

Eine Weiterbildung der Erfindung sieht vor, dass mittels eines Controllers eine Bewegungskurve abgefahren wird.

Insbesondere ist vorgesehen, dass der Controller einen Speicher umfasst, in welchem Bewegungskurven abgespeichert sind. So kann das zu bewegende Bauteil leicht an Hindernissen vorbeigefahren werden.

Alternativ kann der Controller eine Eingabeeinrichtung umfassen, mit welcher die Serviceeinrichtung unmittelbar gesteuert wird. Der Controller kann insbesondere mit Joystick oder Taster oder einem Touchscreen ausgebildet sein.

Die Erfindung sieht insbesondere vor, dass die Serviceeinrichtung einen Controller umfasst, über welchen die Lastaufnahme in zwei horizontalen Raumrichtungen bewegbar ist.

Soll die Lastaufnahme linear Verfahren werden, würde dies schwierig, wenn der Controller unmittelbar angesteuert ist, also beim Ansteuern eine rotatorische Bewegung ausführt.

Die Serviceeinrichtung ist daher derart ausgebildet, dass über den Controller eine lineare Bewegung in eine Richtung eingestellt werden kann, beispielsweise durch Bewegen des Joysticks in eine Richtung, und das über einprogrammierte Bewegungsverläufe diese Linearbewegung aus der rotatorischen Bewegung des Arms und zumindest einer weiteren Linearbewegung etwa der Linearbewegung des Verbindungsstücks am Träger eine insgesamt im Wesentlichen lineare Bewegung erzeugt wird.

Der Controller der Serviceeinrichtung kann gemäß einer Ausführungsform der Erfindung drahtlos mit einer Bedieneinheit gekoppelt werden, insbesondere über eine WLAN- oder Bluetooth-Verbindung. Diese drahtlos gekoppelte Bedieneinheit kann dann beispielsweise ein Smartphone, ein Laptop oder ein Tablet-PC sein.

Der Controller kann jedoch auch mit einer drahtgebundenen Bedieneinheit verbunden sein. Die Trennung von Bedieneinheit und Controller hat den Vorteil, dass Servicearbeiten leichter durchgeführt werden können. Die Bedieneinheit kann auch über Lage- oder Beschleunigungssensoren verfügen, so dass die Serviceeinrichtung über beispielsweise Gesten gesteuert werden kann.

Als Controller kann vorzugsweise ein bereits vorhandener Computer verwendet werden. Dieser kann insbesondere auch als Tablet oder Smartphone ausgebildet sein.

### Kurzbeschreibung der Zeichnungen

Der Gegenstand der Erfindung soll im Folgenden bezugnehmend auf Ausführungsbeispiele anhand der Zeichnungen Fig. 1 bis Fig. 40 näher erläutert werden.

Fig. 1 ist eine perspektivische Ansicht eines Ausführungsbeispiels einer erfindungsgemäßen Serviceeinrichtung.

Fig. 2 zeigt die in Fig. 1 dargestellte Serviceeinrichtung im zusammengelegten Zustand.

Fig. 3 ist eine Detailansicht.

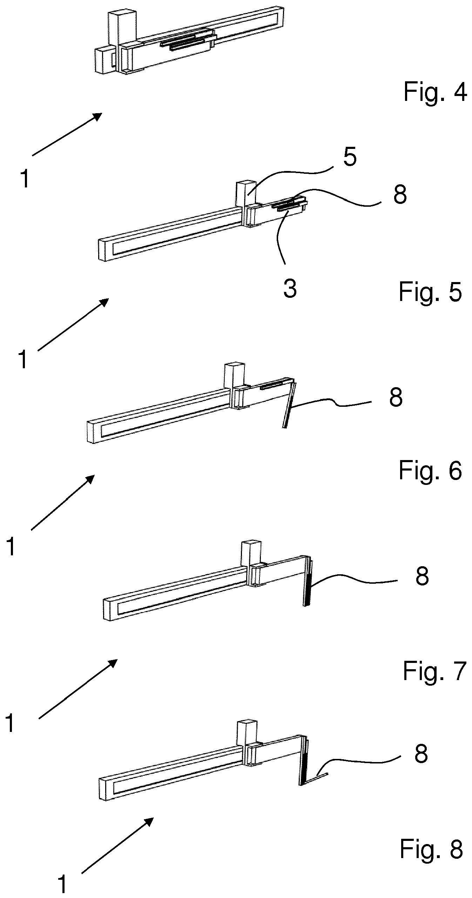

Bezugnehmend auf Fig. 4 bis Fig. 8 soll das Ausklappen einer Serviceeinrichtung näher erläutert werden.

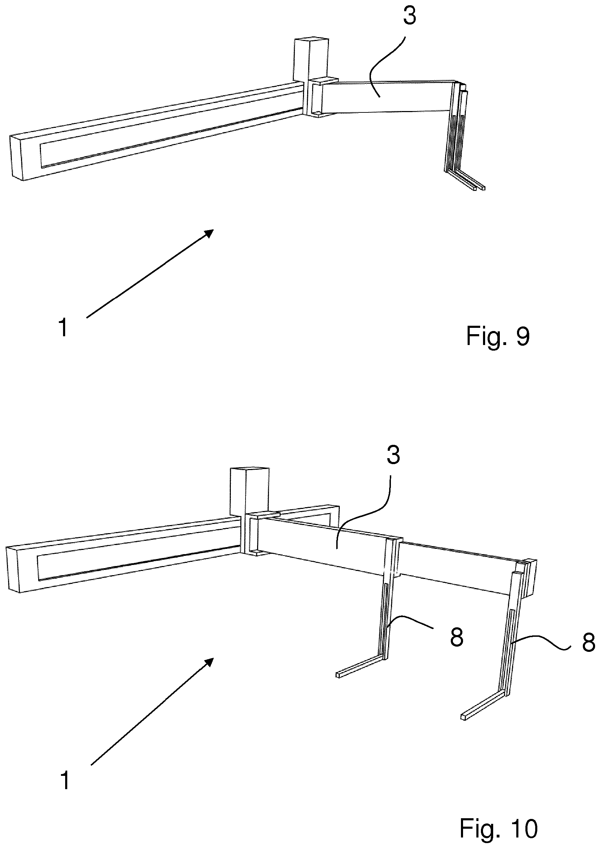

Fig. 9 bis Fig. 15 sind weitere Detailansichten der Serviceeinrichtung, bei denen die Komponenten der Serviceeinrichtung in verschiedenen Bewegungszuständen dargestellt werden.

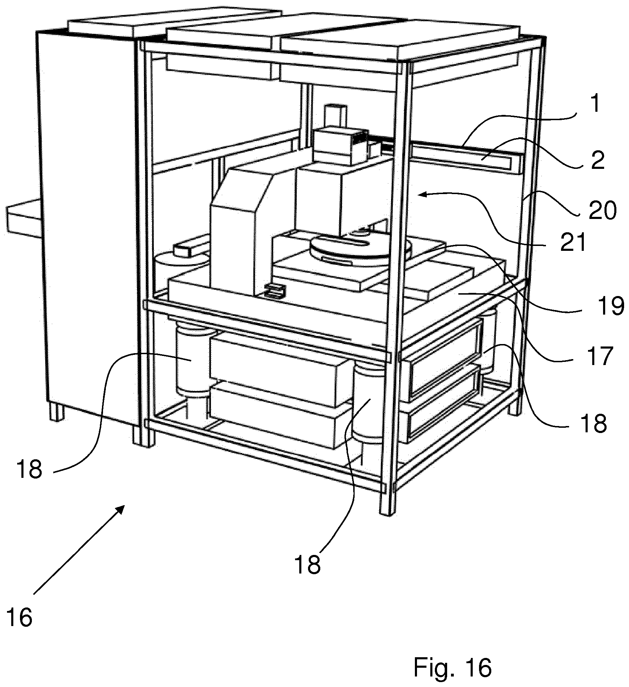

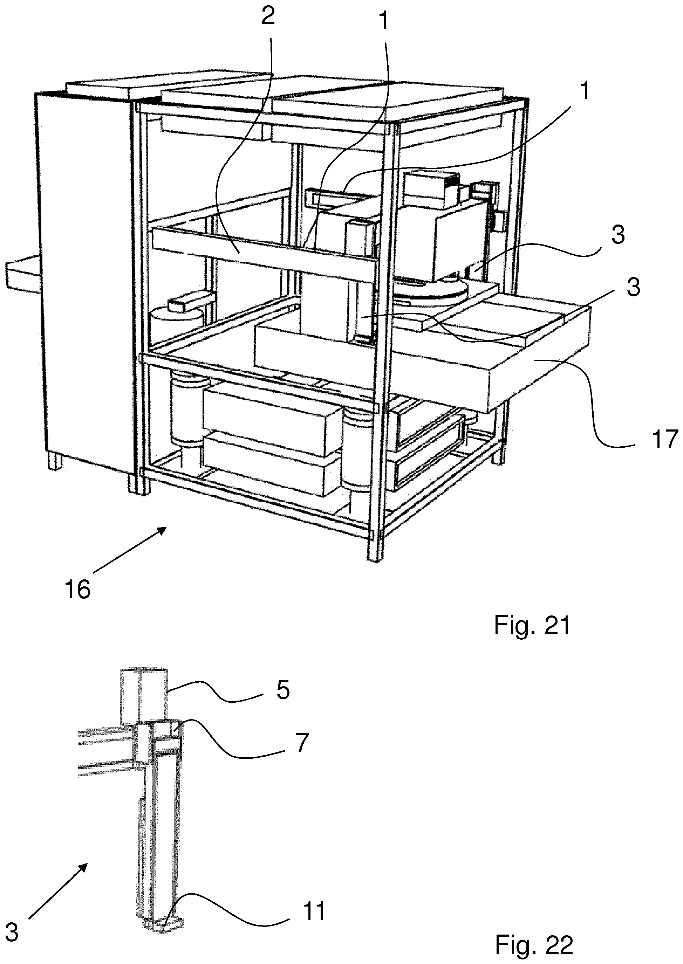

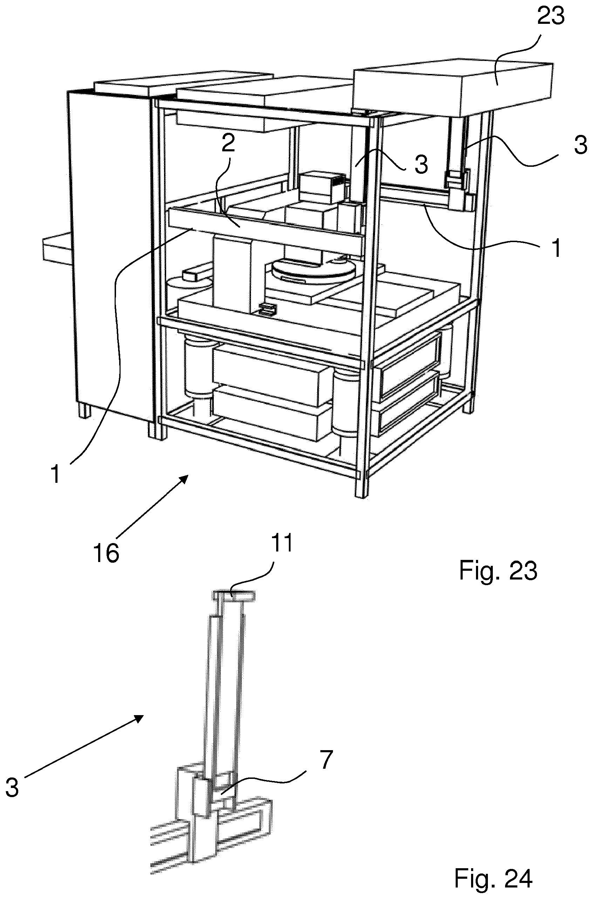

Fig. 16 bis Fig. 24 zeigen verschiedene Anwendungsbeispiele einer Serviceeinrichtung in einer Anlage zur Prozessierung von Halbleiterbauteilen, wobei Fig. 22 und Fig. 24 Detaildarstellungen der Serviceeinrichtung sind.

Fig. 24 ist eine Detailansicht der Serviceeinrichtung, wie sie in Fig. 23 verwendet wird.

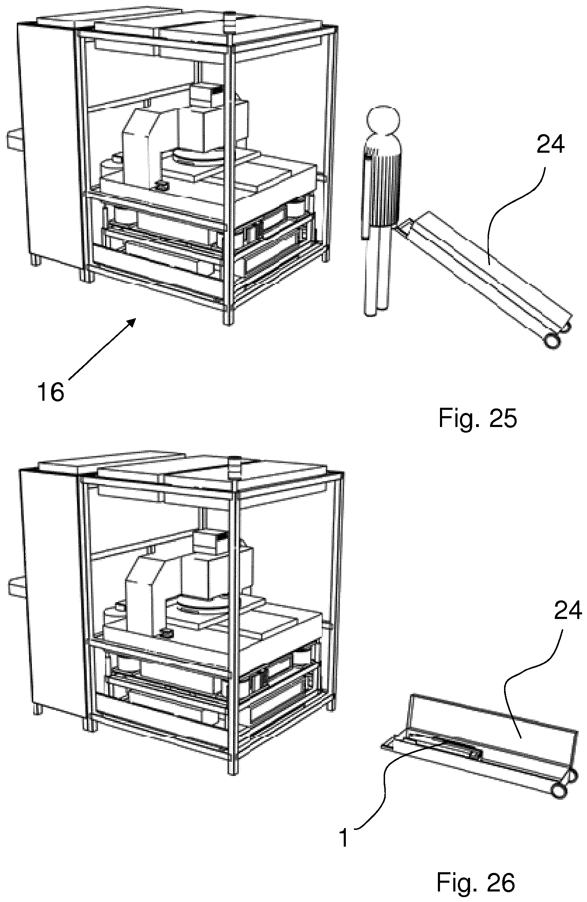

Bezugnehmend auf Fig. 25 bis Fig. 28 soll das Aufstellen einer erfindungsgemäßen Serviceeinrichtung näher erläutert werden. Diese Ausführungsform einer erfindungsgemäßen Serviceeinrichtung wird nur temporär an der Anlage montiert.

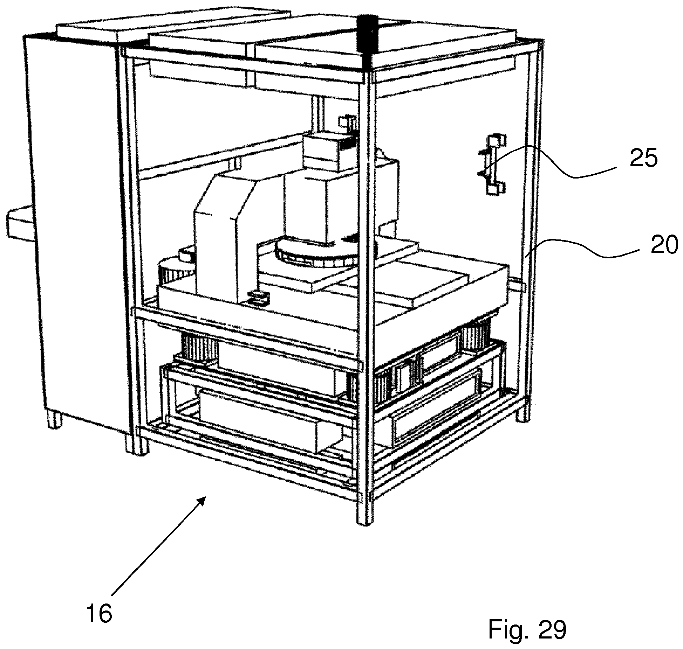

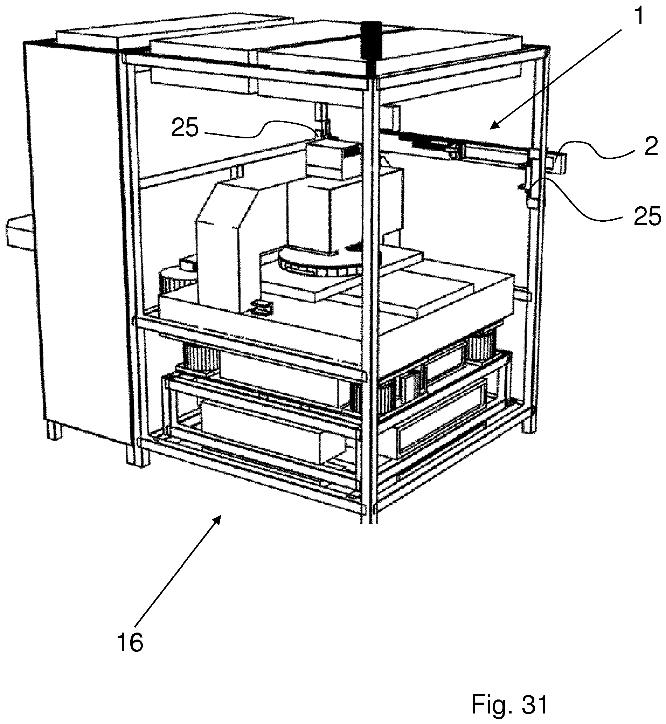

Fig. 29 bis Fig. 31 zeigen das Aufstellen einer Serviceeinrichtung unter Verwendung eines Schnellspannmechanismus.

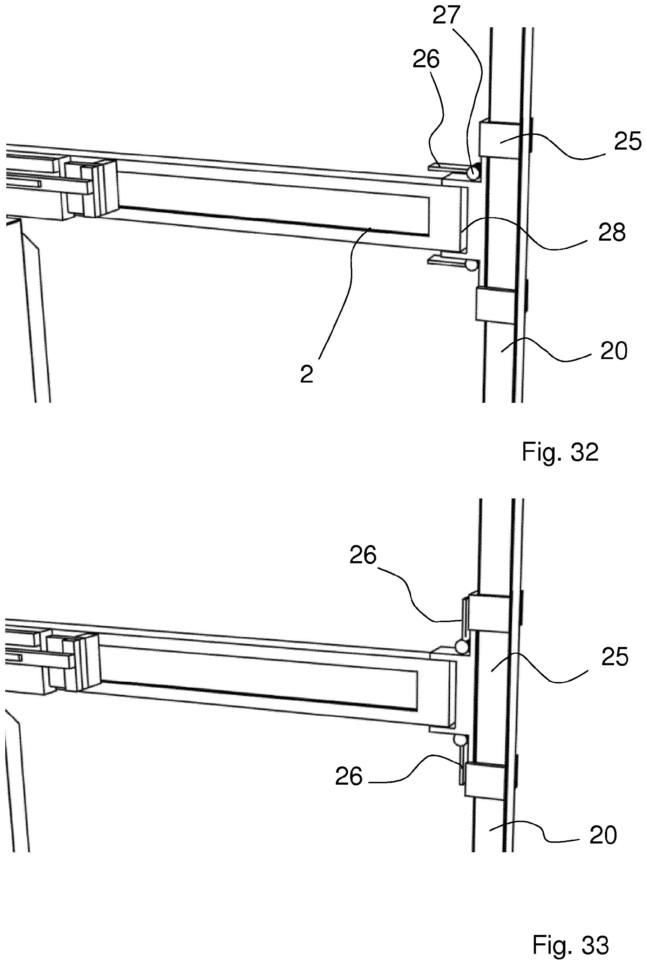

Fig. 32 und Fig. 33 sind Detailansichten des Schnellspannmechanismus.

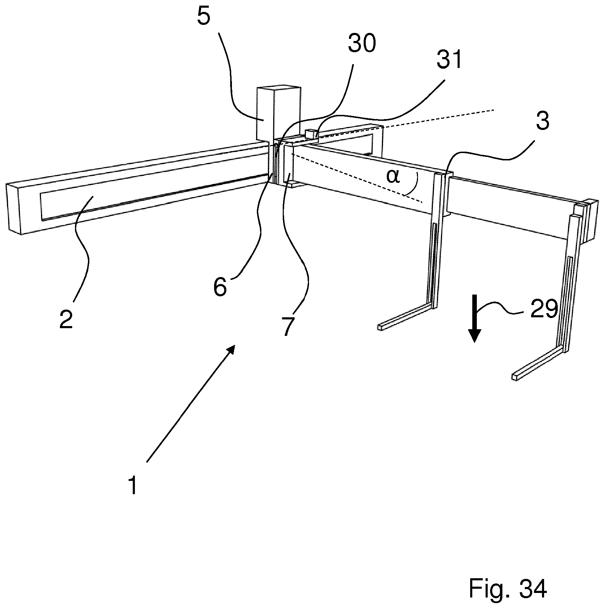

Fig. 34 zeigt eine Serviceeinrichtung, welche ein Scharnier zur Nivellierung des Winkels des Arms der Serviceeinrichtung aufweist.

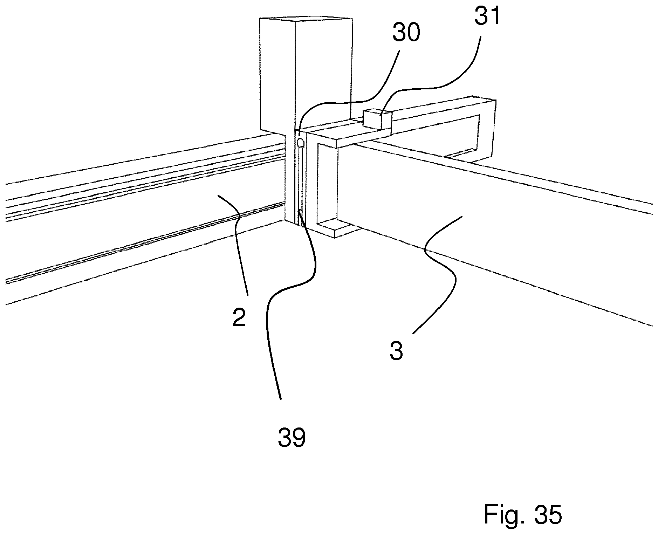

Fig. 35 ist eine Detailansicht der in Fig. 34 dargestellten Serviceeinrichtung.

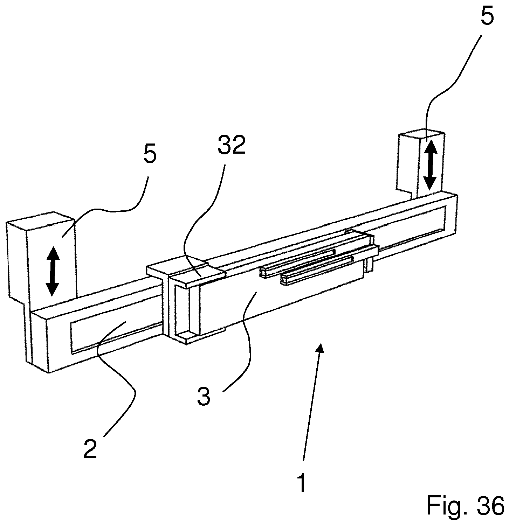

Fig. 36 ist eine den vorangehenden Zeichnungen gegenüber alternative Ausführungsform einer Serviceeinrichtung in perspektivischer Darstellung. Diese umfasst zwei vertikale Antriebe.

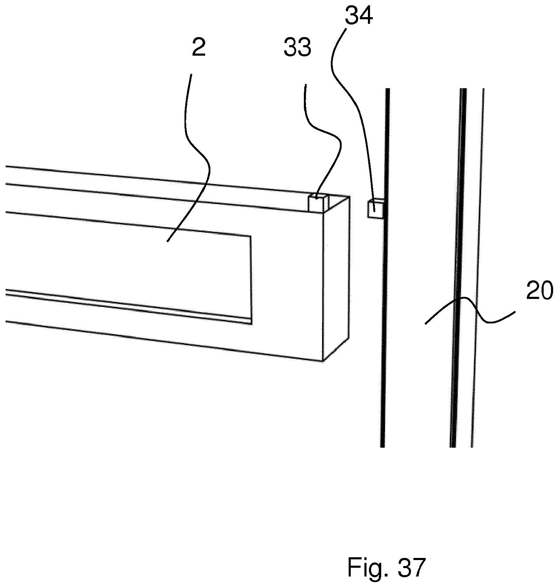

Fig. 37 ist eine Detaildarstellung einer Serviceeinrichtung mit einem Lesegerät und einem Speicher mit teaching-Daten.

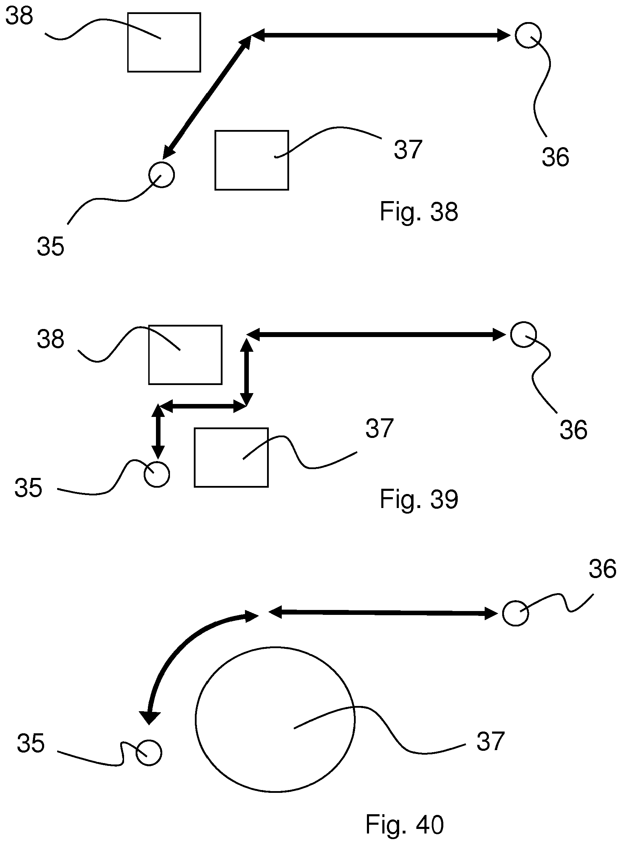

Bezugnehmend auf Fig. 38 bis Fig. 40 soll ein Verfahren zum Bewegen von Bauteilen, bei dem eine erfindungsgemäße Serviceeinrichtung verwendet wird, näher erläutert werden.

### Detaillierte Beschreibung der Zeichnungen

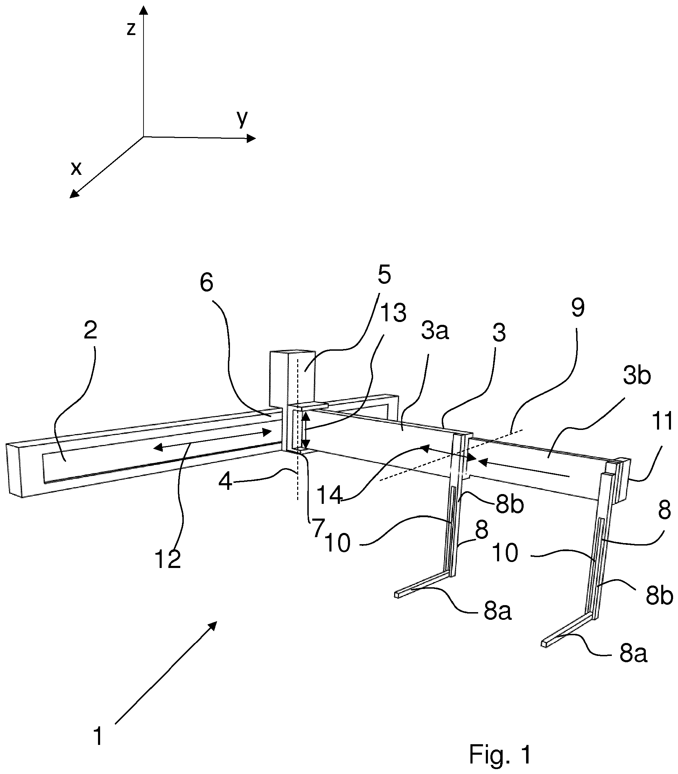

Fig. 1 zeigt ein erstes Ausführungsbeispiel einer Serviceeinrichtung 1. Die Serviceeinrichtung 1 umfasst einen Träger 2, welcher beispielsweise zur Montage an einer Anlage zur Prozessierung von Halbleiterbauelementen ausgebildet ist.

Der Träger 2 ist schienenförmig ausgestaltet und kann im aufgestellten Zustand der Serviceeinrichtung horizontal ausgerichtet sein, d.h. die Haupterstreckungsrichtung des Trägers 2 verläuft horizontal. In dieser Darstellung mit eingezeichnetem Koordinatensystem ist dies die x-y-Ebene. Die als z bezeichnete Raumrichtung ist im Sinne der Erfindung die vertikale Raumrichtung.

An dem Träger 2 ist mittels eines Verbindungsstücks 5, welches einen vertikalen Antrieb für eine Armaufnahme 7 enthalten kann, ein Arm 3 schwenkbar angeschlagen.

Der Arm 3 kann in diesem Ausführungsbeispiel horizontal, also entlang der Achse 4, an dem Träger 2 verschwenkt werden. Hierzu weist das Verbindungsstück 5 ein Scharnier auf.

In diesem Ausführungsbeispiel ist der Arm 3 um 180° schwenkbar, kann also mit beiden Seiten an den Träger 2 geklappt werden.

Das Verbindungsstück 5 umfasst des Weiteren eine Armaufnahme 7 sowie eine Trägeraufnahme 6.

Die Trägeraufnahme 6 kann entlang des Trägers 2 horizontal verfahren werden. Die entsprechende Bewegung wird durch den Pfeil 12 symbolisiert.

Weiter ist die Armaufnahme 7 gegenüber der Trägeraufnahme 6 vertikal verfahrbar, was durch den Pfeil 13 symbolisiert wird.

Durch Hochfahren der Armaufnahme 7 wird der Arm 3 und damit ein zu bewegendes Bauteil angehoben, welches sodann durch eine horizontale Bewegung aus dem Anlagenbereich herausgefahren werden kann.

Der Arm 3 ist in diesem Ausführungsbespiel wiederum in die Segmente 3a und 3b unterteilt welche teleskopartig ineinander schiebbar sind, d.h. das Segment 3b kann in das Segment 3a geschoben werden, um den Arm 3 zu verkürzen bzw. zu verlängern.

In einer alternativen, hier nicht dargestellten Ausführungsform der Erfindung, kann der besteht der Arm 3 nur aus dem Segment 3a bestehen, an dem dann die Gabeln 8 befestigt sind,

Um ein Bauteil aufzunehmen, umfasst der Arm 3 auf einer Seite die Gabeln 8, welche hier im ausgeklappten Zustand dargestellt sind. Die Gabeln 8 bestehen aus einem Oberteil 8b und einem Unterteil 8a, welches in eine Ausnehmung 10 des Oberteils geklappt werden kann.

Das Bauteil kann aber auch ohne die Gabeln aufgenommen werden, indem es beispielsweise am Arm 3a direkt befestigt wird.

Eine Gabel 8 ist am Segment 3a und die andere Gabel am Segment 3b angeschlagen.

Die Gabeln 8 sind des Weiteren in diesem Ausführungsbeispiel horizontal entlang des Arms 3 bzw. entlang des jeweiligen Segments 3a, 3b verschiebbar, was durch den Pfeil 14 symbolisiert wird.

So kann der Abstand der Gabeln 8 variiert werden.

Weiter ist in diesem Ausführungsbeispiel das Oberteil 8b der Gabeln drehbar am Arm 3 angeordnet;). Die Drehachse 9 verläuft senkrecht zur Oberseite des Arms 3.

In einer alternativen hier nicht dargestellten Ausführungsform der Erfindung sind die Oberteile nicht drehbar ausgestaltet.

Mithin können die Gabeln 8 so gedreht werden, dass deren Haupterstreckungsrichtung mit der Haupterstreckungsrichtung des Arms 3 übereinstimmt. Die Serviceeinrichtung 1 kann so zusammengelegt werden.

Auf der den Gabeln 8 gegenüberliegenden Seite des Arms 3 ist am Ende des Arms 3 bzw. des Segments 3b in diesem Ausführungsbeispiel eine Aufnahme 11 vorgesehen, welche dazu dient, schwere Lasten anzuheben. Die Aufnahme 11 ist in diesem Ausführungsbeispiel als einfacher Winkel ausgebildet.

Es versteht sich, dass sowohl die Gabeln 8 als auch die Aufnahme 11 noch weitere Verriegelungskomponenten zum Sichern des Bauteils während des Transports aufweisen können, welche hier nicht dargestellt sind.

Weiter nicht dargestellt ist eine optionale Verriegelung des Arms 3 in der jeweiligen Schwenkposition sowie der Segmente 3a, 3b zueinander.

Bei einer Ausführungsform wird die Serviceeinrichtung 1 komplett manuell bedient. Beispielsweise über einen Kurbelantrieb kann das Verbindungsstück 5 entlang des Trägers 2 verfahren werden.

Vorzugsweise ist ebenfalls ein Kurbelantrieb vorgesehen, um den Arm 3 über die Armaufnahme 7 in vertikaler Richtung zu verfahren.

Das Verschwenken des Arms 3 sowie das Ausziehen des Segments 3b und das Ausklappen der Gabeln 8 kann manuell erfolgen.

Bei einer alternativen Ausführungsform der Erfindung erfolgen die Linearbewegungen entlang der Pfeile 12 und 13 sowie optional auch das Ausfahren des Segments 3b motorisch. Bei einer Ausführungsform der Erfindung kann erfolgt auch die Schwenkbewegung des Armes 3 motorisch.

Die Bedienung kann über Tasten an einem Controller oder über eine Schnittstelle und eine externe Einheit realisiert werden. Eine derartige Steuerung ist nur erforderlich, wenn die Achsen nicht manuell gesteuert werden, und auch keine weiteren Aktoren oder Sensoren der Serviceeinrichtung eine Steuerung benötigen.

Optional kann die Serviceeinrichtung 1 noch Sensoren enthalten, um insbesondere die Höhe eines angehobenen Bauteils nivellieren zu können.

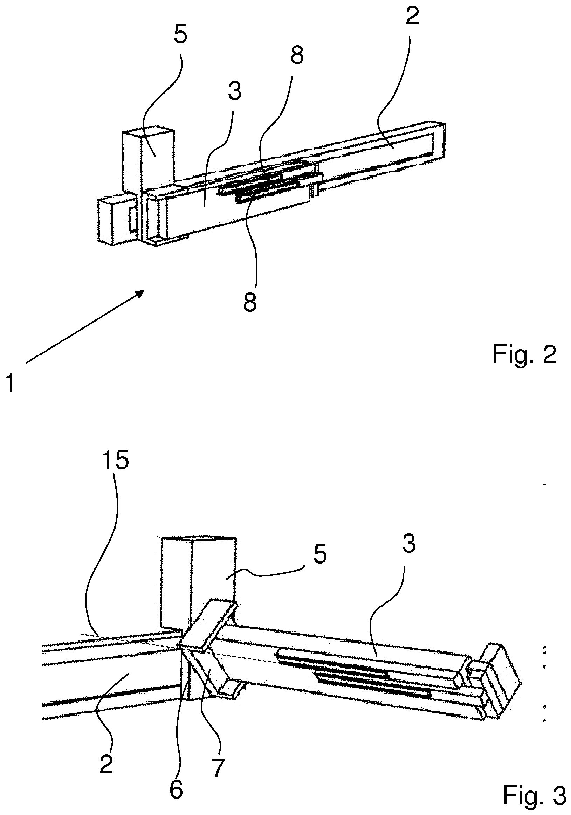

Fig. 2 zeigt die Serviceeinrichtung 1 im zusammengeklappten Zustand.

Zu erkennen ist, dass die Segmente des Arms 3 zusammengeschoben sind und dass nunmehr der Arm 3 an dem Träger 2 anliegt.

Die Gabeln 8 sind ebenfalls zusammengeklappt und liegen auf dem Arm 3 auf.

In dieser Ansicht wird deutlich, dass die Serviceeinrichtung 1 auf einfache Weise zu einer kompakten mobilen Einheit zusammengefaltet werden kann.

Seitlich über den Träger hinaus steht lediglich das Verbindungsstück 5. Dieses ist vorzugsweise aber deutlich kürzer, vorzugsweise weniger als 1/3 so lang wie der Träger 2. Ein seitlich über den Träger 2 hinausstehendes Verbindungsstück 5 wird benötigt, um das zu bewegende Bauteil vertikal anzuheben, sofern die Serviceeinrichtung über eine vertikale Verfahreinrichtung verfügt.

Fig. 3 ist eine Detailansicht des in Fig. 2 dargestellten Arms 3, welcher mittels des Verbindungsstücks 5 am Träger 2 befestigt ist.

In dieser Ansicht ist zu erkennen, dass die Armaufnahme 7 gegenüber der Trägeraufnahme 6 drehbar ist.

Die Drehachse 15 verläuft in der horizontalen Ebene entlang der Haupterstreckungsrichtung des Arms 3. Dadurch, dass der Arm 3 drehbar ist, kann sich dieser nach einer Drehung um 90° gegenüber der in Fig. 1 dargestellten Position nach oben oder nach unten erstrecken, also dass die Haupterstreckungsrichtung des Arms 3 dann vertikal verläuft.

Bezugnehmend auf Fig. 4 bis Fig. 8 soll das Ausklappen einer Serviceeinrichtung 1 erläutert werden.

Fig. 4 zeigt entsprechend der Fig. 2 die Serviceeinrichtung 1 in zusammengeklapptem Zustand.

In Fig. 5 ist bei der Serviceeinrichtung 1 nunmehr das Verbindungsstück 5 vom linken Ende des Arms 3 zum rechten Ende des Arms 3 gefahren worden. Der Benutzer kommt nunmehr gut an den Arm 3 und an die in diesem Ausführungsbeispiel enthaltenen und am Arm angeordneten Gabeln 8.

Wie in Fig. 6 und Fig. 7 dargestellt, können nunmehr die Gabeln 8 um 90° gedreht werden, so dass die Haupterstreckungsrichtung der noch zusammengeklappten Gabeln 8 vertikal verläuft.

Sodann kann, wie in Fig. 8 dargestellt, das Unterteil 8a der (in diesem Ausführungsbeispiel klappbaren) Gabeln herausgeklappt werden, so dass die Gabeln 8 eine L-förmige Anordnung bilden.

Fig. 9 zeigt, wie nunmehr der Arm 3 horizontal verschwenkt wird, etwa um diesen über einem Anlagenbereich zu positionieren, in welchem sich ein anzuhebendes Bauteil befindet.

Wie in Fig. 10 dargestellt, kann sodann der Arm 3 (der in diesem Ausführungsbeispiel auseinanderziehbaren Ausführung) auseinandergezogen werden, so dass nunmehr die Gabeln 8 voneinander beabstandet sind.

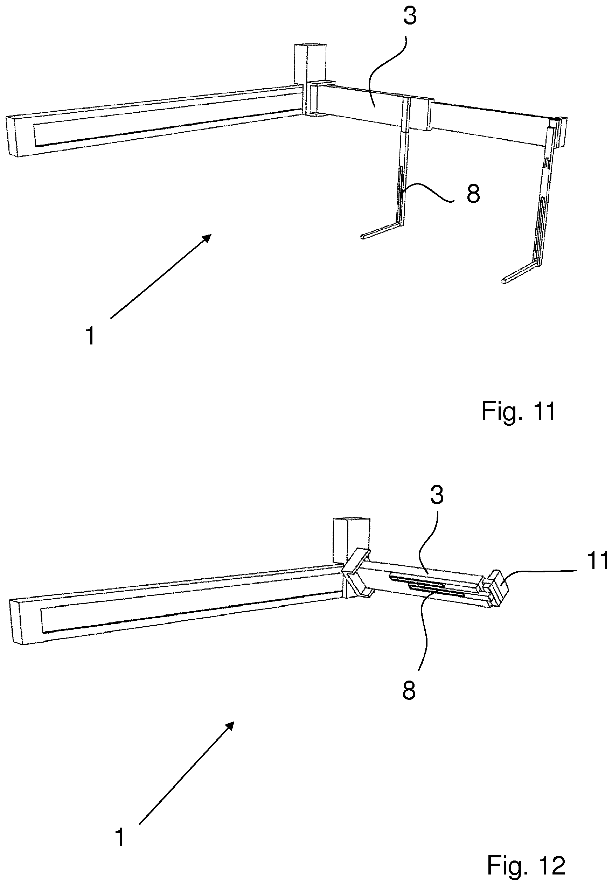

Wie in Fig. 11 zu erkennen, ist in diesem Ausführungsbeispiel zumindest eine Gabel 8 horizontal entlang des Arms 3 verschiebbar.

Fig. 12 zeigt eine weitere Detailansicht, bei welcher sich in diesem Ausführungsbeispiel der Arm 3 gerade dreht, etwa um Gabeln 8 und Aufnahme 11 auf die jeweils gegenüberliegende Seite des Arms 3 zu versetzen.

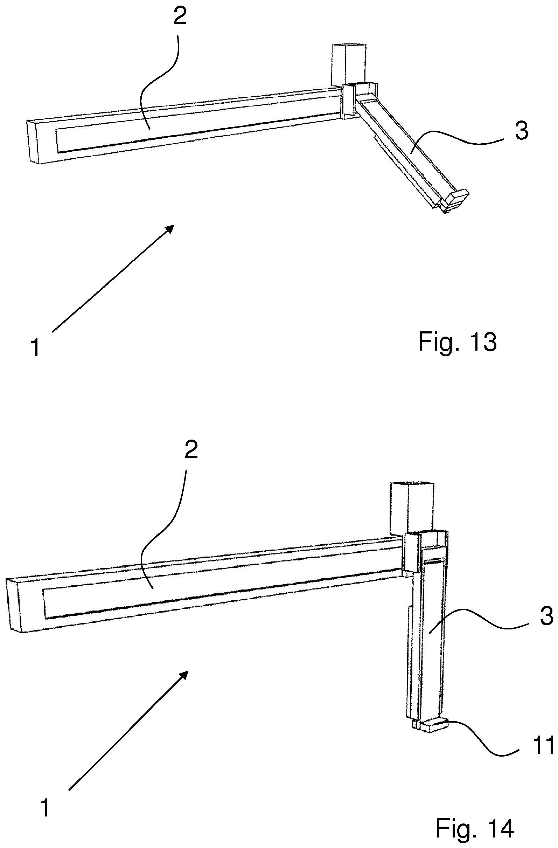

Weiter kann, wie in Fig. 13 dargestellt, der Arm 3 auch derart gedreht werden, dass dieser nicht mehr horizontal zum Träger 2 verschwenkt wird, sondern nach oben oder unten geklappt werden kann.

In Fig. 14 ist dargestellt, wie der Arm 3 vollständig nach unten geklappt ist. Der Arm 3 ist in dieser Position nicht dazu ausgebildet, von der Seite her in einen Anlagenbereich eingeschwenkt zu sein. Vielmehr kann der Arm über das Verbindungsstück horizontal verfahren werden. Vielmehr kann in dieser Position mittels der Aufnahme 11 eine schwere Last seitlich angehoben werden.

Eine Bewegung deutlich schwererer Lasten als in der zur Seite verschenkten Position ist so möglich, da nunmehr der Arm 3 keinen langen Hebel zum Träger 2 bildet.

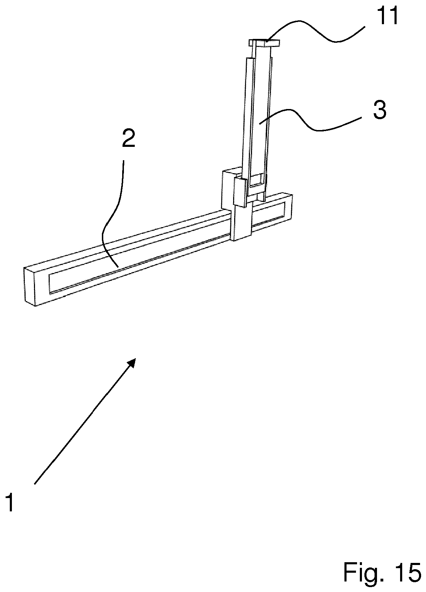

Wie in Fig. 15 dargestellt, kann der Arm 3 auch nach oben geklappt werden, so dass sich nunmehr die Aufnahme 11 oberhalb des Trägers 2 befindet.

Fig. 16 zeigt in einer perspektivischen Ansicht eine Anlage 16 zur Prozessierung von Halbleiterbauelementen.

Die Anlage 16 umfasst einen Tisch 17, welcher auf Schwingungsisolatoren 18 gelagert ist.

Auf dem Tisch 17, welcher vorzugsweise als Granitplatte ausgebildet ist, ist eine bewegbare Stage 19 angebracht, welche Teil der Anlage 16 zur Prozessierung von Halbleiterbauelementen, in diesem Beispiel einer Anlage 16 mit einem Metrologie-Gerät 21, ist.

Die Anlage 16 wird vorzugsweise in einem Reinraum verwendet.

Die Anlage 16 umfasst des Weiteren einen Rahmen 20. Innerhalb des Rahmens 20 ist der Sensor des Metrologie-Gerätes 21 angeordnet.

Wie nunmehr in dieser Darstellung zu erkennen, ist am Rahmen 20 der Träger 2 der zuvor dargestellten Serviceeinrichtung 1 befestigt.

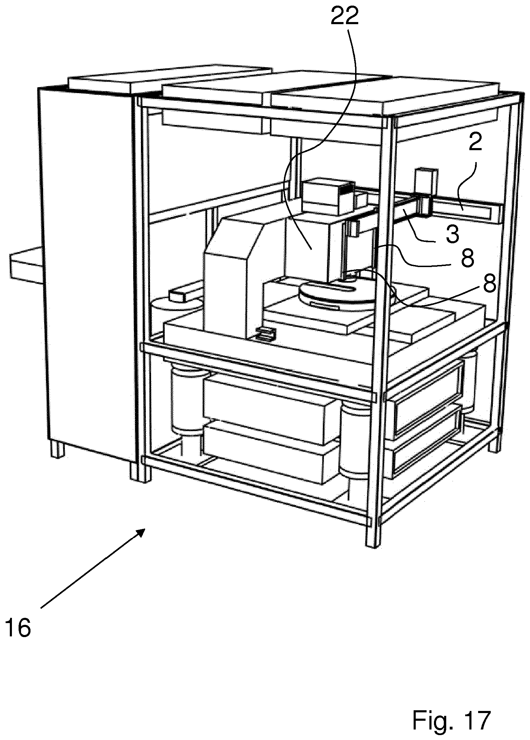

Wie in Fig. 17 dargestellt, kann der Arm 3 horizontal vom Träger 2 weggeschwenkt werden und mittels der Gabeln 8 wird in diesem Ausführungsbeispiel ein beispielsweise optischer Sensor 22 von unten gegriffen. Durch eine optionale Vakuumansaugung oder durch eine mechanische Verriegelung oder durch eine magnetische Verriegelung kann das Bauelement, wie in diesem Ausführungsbeispiel der optische Sensor 22 auf den Gabeln 8 gegen Verrutschen gesichert werden (nicht dargestellt).

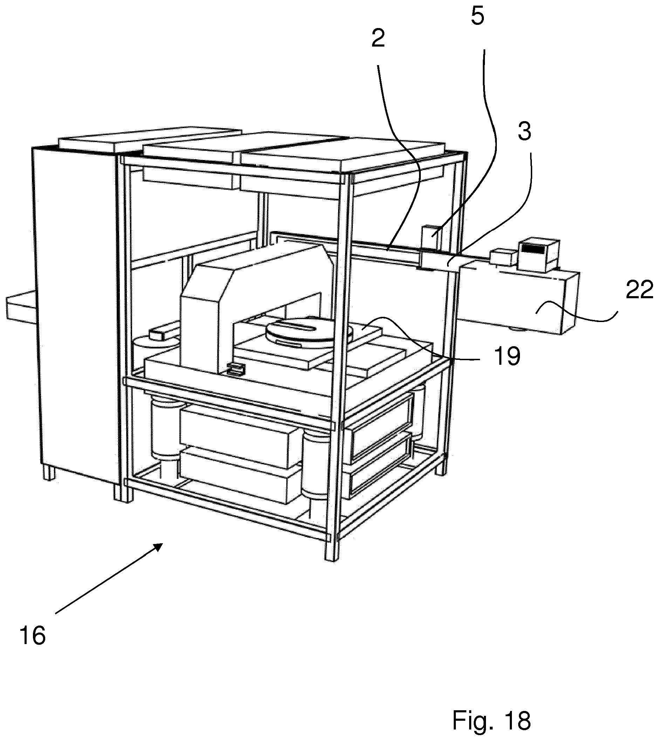

Wie in Fig. 18 dargestellt, kann das Bauteil, in diesem Ausführungsbeispiel der optische Sensor 22, über eine Schwenkbewegung des Arms 3 auf einfache Weise aus dem Anlagenbereich herausbewegt und so entnommen werden, oder Arbeiten an ihr durchgeführt werden. Hierzu wurde das Verbindungsstück 5 horizontal entlang des Trägers 2 verfahren.

Die Stage 19, der optische Sensor 22, oder andere Teile der Metrologie-Anlage sind nunmehr für Wartungsarbeiten zugänglich.

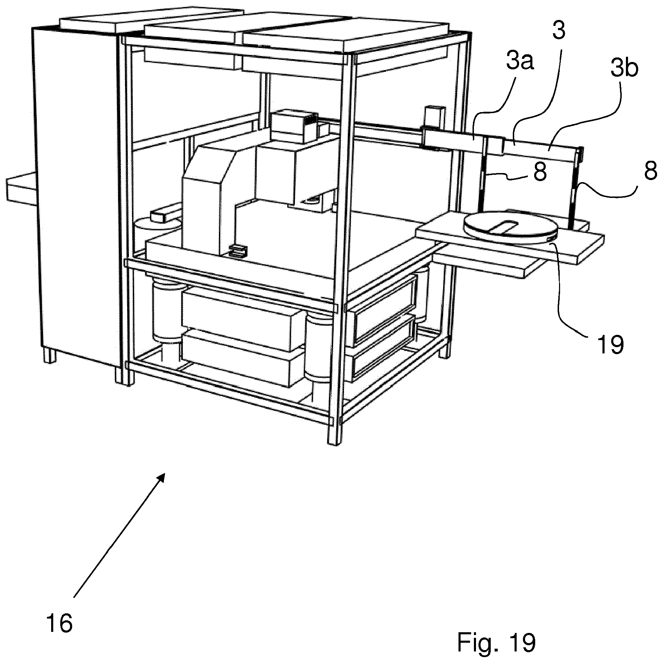

Wie in Fig. 19 dargestellt, kann auch die Stage 19 mittels der Arme 8 aus dem Anlagenbereich herausgeschwenkt werden.

Hierzu ist in diesem Ausführungsbeispiel der Arm 3 verlängert, indem das Segment 3b aus dem Segment 3a herausgefahren wurde. Die Gabeln 8 haben nunmehr gegenüber dem in Fig. 17 dargestellten Zustand einen breiteren Abstand.

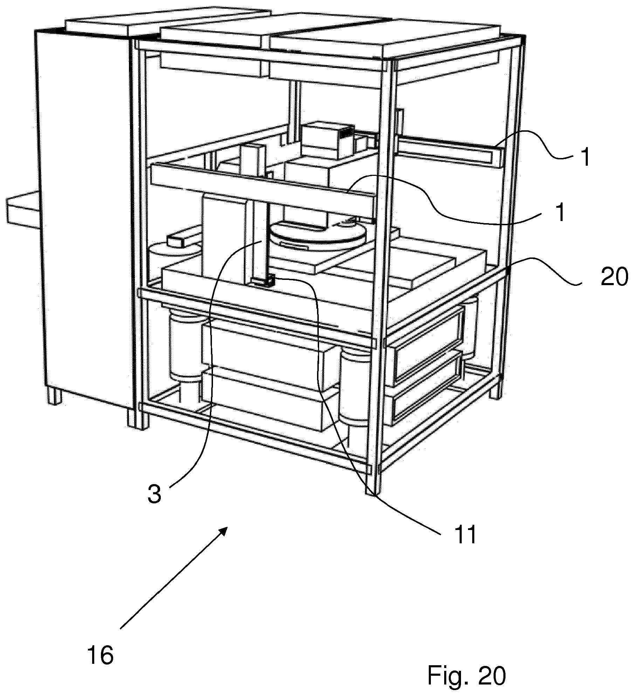

Bezugnehmend auf Fig. 20 bis Fig. 24 soll das Bewegen von schwereren Komponenten erläutert werden.

Fig. 20 zeigt wiederum eine Anlage 16 zur Prozessierung von Halbleiterbauelementen.

Im Unterschied zu den vorangehenden Zeichnungen sind nunmehr zwei Serviceeinrichtungen 1 am Rahmen 20 der Anlage 16 montiert, welche sich gegenüberliegen.

Die Arme 3 der jeweiligen Serviceeinrichtung 1 werden nicht horizontal in den Anlagenbereich hineingeschwenkt, sondern wurden durch eine Drehbewegung von 90° in eine Position gebracht, bei welcher die Arme 3 nach unten geschwenkt werden können derart, dass die winkelförmige Aufnahme 11 das untere Ende des Arms 3 bildet.

Die schwenkbaren Arme können in anderen Ausführungsbeispielen auch durch andere, insbesondere nicht schwenkbare Bauteile ersetzt werden, welche das zu bewegende Teil (in diesem Ausführungsbeispiel den Tisch 17) mit der Serviceeinrichtung verbinden.

Wie in Fig. 21 dargestellt, kann mittels der Arme 3 der gesamte Tisch 17 teilweise aus dem Anlagenbereich herausgefahren werden, indem dieser mittels der Arme 3 und der Aufnahme 5 angehoben wird und der Arm entlang des Trägers 2 verfahren wird.

Die Serviceeinrichtungen 1 können hierzu synchronisierte horizontale und/oder vertikale Antriebe aufweisen (nicht dargestellt). Diese Synchronisation kann bei motorischen horizontalen und/oder vertikalen Antrieben über die Antriebssteuerung erfolgen, oder kann insbesondere bei manuellen horizontalen und/oder horizontalen Antrieben über eine mechanische Verbindung, beispielsweise über eine Verbindungswelle mit einer Ankopplung an die Bewegungsachsen, erfolgen.

Fig. 22 ist eine Detailansicht des nach unten geschwenkten Arms 3, welcher zum Anheben des Tisches über die Armaufnahme 7 entlang des Verbindungsstücks 5 nach oben gefahren werden kann.

Fig. 23 zeigt, dass mittels der beiden Serviceeinrichtungen 1 auch oberhalb der Serviceeinrichtung 1 angeordnete schwere Lasten bewegt werden können. Hierzu sind die Arme 3 vertikal nach oben geklappt und können so weitere Bauteile, insbesondere die hier dargestellte Filterbaugruppe 23 der Anlage 16 anheben (und seitlich entlang der Träger 2 verfahren.

Fig. 24 zeigt wiederum eine Detailansicht des Arms 3.

Zu erkennen ist, dass der Arm 3 vertikal nach oben verschwenkt ist, so dass die Aufnahme 11 sich an einem oberen Ende des Arms 3 befindet. Ein Anheben der Last ist wiederum durch ein Bewegen der Armaufnahme 7 möglich.

Bezugnehmend auf Fig. 25 bis Fig. 28 soll die Montage einer erfindungsgemäßen Serviceeinrichtung näher erläutert werden.

Wie in Fig. 25 dargestellt, kann sich die Serviceeinrichtung im zusammengeklappten Zustand in einen Rollkoffer 24 befinden, welcher vom Benutzer zur Anlage verbracht werden kann.

Fig. 26 zeigt den geöffneten Rollkoffer, in welchem sich die Serviceeinrichtung 1 im zusammengeklappten Zustand befindet.

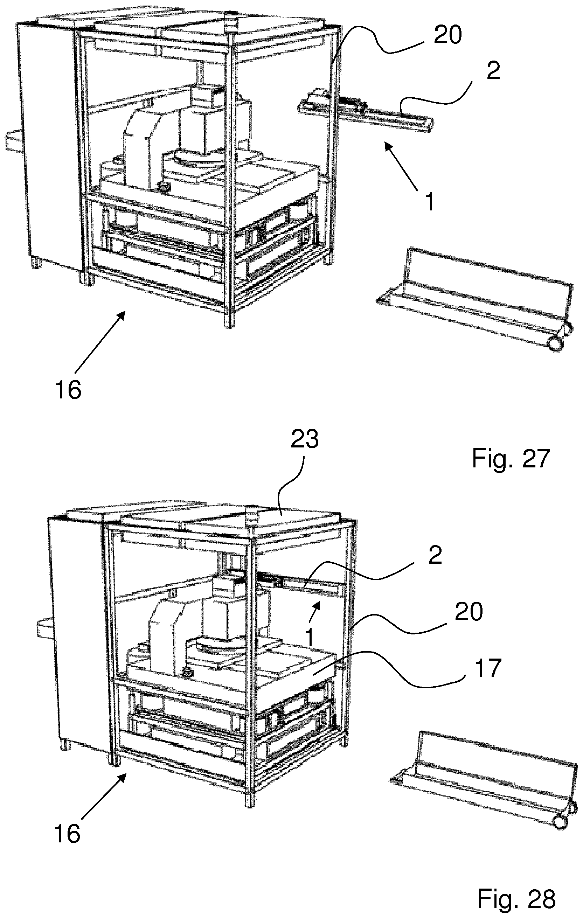

Sodann kann, wie in Fig. 27 und Fig. 28 dargestellt, der Träger 2 der Serviceeinrichtung 1 am Rahmen 20 der Anlage 16 montiert werden. Die Serviceeinrichtung 1 befindet sich zwischen einem oberen Anlagenteil 23 der Anlage und dem Tisch 17 der Anlage 16.

Ein gegebenenfalls vorhandener Controller (nicht dargestellt) der Serviceeinrichtung 1 kann sich ebenfalls mit im Rollkoffer 24 befinden. Der Controller ist gemäß einer alternativen Ausführungsform Teil der Anlage selbst und muss dadurch nicht mit zur Anlage verbracht werden.

Eine Montage kann beispielsweise durch Verschrauben am Träger 20 erfolgen.

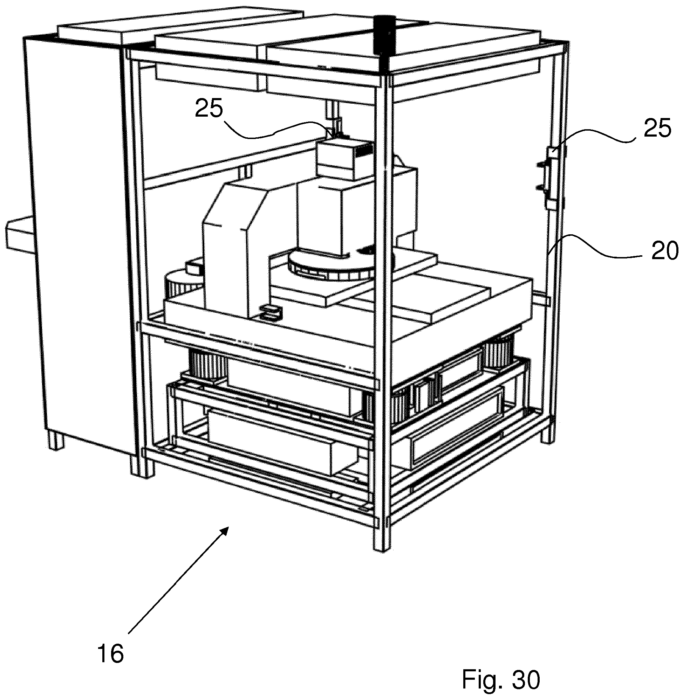

Vorzugsweise wird aber, wie bezugnehmend auf Fig. 30 bis Fig. 31 näher erläutert wird, ein Schnellspannmechanismus verwendet.

Wie in Fig. 29 dargestellt, kann zum Anbringen der Serviceeinrichtung ein Adapter 25 verwendet werden.

Dieser kann beispielsweise form- oder kraftschlüssig am Rahmen 20 befestigt werden.

Bei einer Ausführungsform werden verschiedenartige Adapter dem Servicetool beigelegt, um dieses an verschieden ausgebildeten Anlagen montieren zu können. Insbesondere können Adapter in unterschiedlicher Breite vorhanden sein, die dem jeweiligen Anlagenprofil des Rahmens 20 verschiedener Anlagen 16 angepasst sind.

Wie in Fig. 30 dargestellt, wird der Adapter 25 am Rahmen 20 befestigt. Der Adapter kann insbesondere klammerartig ausgebildet sein und mit dem Rahmen kraft- und/oder formschlüssig verbunden werden.

Sodann kann der Träger 2 der Serviceeinrichtung 1 an den Adaptern 25 vorzugsweise mittels eines Schnellspannmechanismus angebracht werden.

Dies ist in Fig. 32 und Fig. 33 im Detail gezeigt.

Der Schnellspannmechanismus des Adapters 25 weist in diesem Ausführungsbeispiel jeweils Hebel 26 mit einem Exzenter 27 auf. Der Träger 2 ist in einer Ausnehmung 28 des Adapters angeordnet.

Wie in Fig. 33 dargestellt, wird durch Umlegen der Hebel 26 der Schnellspannmechanismus des Adapters 25 verriegelt.

Es versteht sich, dass aber auch die Verwendung von anders ausgebildeten Form- oder Kraftschlusselementen möglich ist.

Fig. 34 zeigt ein weiteres Ausführungsbeispiel einer Serviceeinrichtung. Bei dieser Ausführungsform umfasst das Verbindungsstück 5 ein Ausgleichsgelenk 30, welches zwischen der Armaufnahme 7 und der Trägeraufnahme 6 angeordnet ist.

Wie über den Pfeil 29 symbolisiert, übt eine aufgenommene Last eine Kraft auf den Arm 3 aus, welche dazu führt, dass der Arm 3 aufgrund des langen Hebels und der nichtunendlichen Steifigkeit des Systems um den Winkel α verdreht wird.

Dies resultiert in einer Höhenänderung und insbesondere eine Winkeländerung der Last.

Über einen Sensor 31 wird eine derartige Winkeländerung erfasst und kann mittels eines Aktors (nicht dargestellt) über das Ausgleichsgelenk 30 kompensiert werden, indem der Arm 3 über das Ausgleichsgelenk 30 nach oben geschwenkt wird.

Dies erfolgt vorzugsweise automatisiert.

Als Aktor kann ein motorischer Aktor verwendet werden. Vorgesehen ist insbesondere die Verwendung eines Piezo-Aktors, eines Elektromotors oder einer Pneumatik. Auch eine manuelle Ausführungsform ist möglich.

Fig. 35 ist eine Detailansicht des Ausgleichsgelenks 30, welches in diesem Ausführungsbeispiel als Festkörpergelenk ausgebildet ist.

Zwischen den beiden Hälften dieses Festkörpergelenks befindet sich der Aktor 39.

Fig. 36 zeigt eine alternative Ausführungsform einer Serviceeinrichtung 1, welche zum Heben von insbesondere schweren Lasten vorgesehen ist. Hierzu umfasst die Serviceeinrichtung zwei Verbindungsstücke 5, an welchen der Träger 2 befestigt ist.

Über die Verbindungsstücke 5 kann, wie in der zuvor dargestellten Ausführungsform, der Träger 2 nach oben gefahren werden und damit das in der Anlage befindliche Bauteil angehoben werden.

An dem Träger ist mittels eines weiteren Verbindungsstücks 32 der Arm 3, welcher der zuvor dargestellten Ausführungsform entspricht, schwenkbar angeschlagen.

Das Verbindungsstück 32 ist in horizontaler Richtung verschiebbar, insbesondere motorisch verfahrbar.

Die Vertikalbewegung erfolgt aber mit den Verbindungsstücken 5.

Weiter ist auch der hier dargestellte Arm mittels des Verbindungsstücks 32 drehbar, um diesen je nach Anwendung in den Anlagenbereich hineinschwenken zu können oder zum Heben von schweren Lasten vertikal nach oben oder unten auszurichten.

Die Erfindung bezieht sich insbesondere auf eine Serviceeinrichtung wie für Teile einer Prozessanlage oder Teile einer Prozesskontrollanlage (beispielsweise ein Messsensor, Teile einer Lithographieanlage, insbesondere Messgeräte, Lithographiegeräte, Metrologiegeräte, optische Inspektionsgeräte, Inspektionsgeräte auf Elektronenstrahlbasis, Beschichtungsanlagen sowie Anlagen zur Bearbeitung von Halbleitersubstraten). Die Erfindung bezieht sich auch auf Anlagen zur Herstellung von Masken für den Halbleiterprozess. Die Erfindung bezieht sich auch auf die Handlingsysteme der oben genannten Anlagen, beispielsweise auf Handling-Roboter. Weiter ist auch eine Verwendung in Anlagen in Reinräumen der Pharma- und Lebensmittelindustrie denkbar, insbesondere bei Produktionspack- und Abfüllanlagen. Weiterhin ist ebenfalls eine Verwendung in Anlagen des Maschinenbaus möglich.

Fig. 37 zeigt eine Detaildarstellung einer Serviceeinrichtung, welche zwei miteinander kommunizierende Komponenten, in diesem Ausführungsbespiel ein Lesegerät 33 und ein Speicher 34, umfasst. Auf dem Speicher 34 sind teaching-Daten hinterlegt. Die Serviceeinrichtung ist ansonsten entsprechend der in Fig. 1 dargestellten Serviceeinrichtung ausgebildet.

Die Serviceeinrichtung umfasst einen Träger 2, welcher anlagenseitig, insbesondere mittels eines Schnellspanners, befestigt werden kann.

In diesem Ausführungsbeispiel ist an dem Träger 2 ein Lesegerät 33 angeordnet, über welches drahtlos ein anlagenseitiger Speicher 34 ausgelesen werden kann, welcher in diesem Ausführungsbeispiel an dem Rahmen 20 der Anlage angebracht ist. Der Speicher 34 kann insbesondere als RFID-Chip ausgebildet sein.

Über das Lesegerät 33 kann nunmehr die Serviceeinrichtung mit teaching-Daten programmiert werden, insbesondere können Bewegungsprofile einprogrammiert sein, um ein spezifisches Anlagenteil aus dem Anlagenbereich herauszubewegen.

Bezugnehmend auf Fig. 38 bis Fig. 40 soll erläutert werden, wie ein Ausführungsbeispiel einer erfindungsgemäßen Serviceeinrichtung, welches insbesondere der in Fig. 1 dargestellten Serviceeinrichtung entsprechen kann, welche also unter anderem einen schwenkbaren Arm umfasst, welcher an einem Träger angeschlagen ist, zum Anheben und Bewegen eines Bauteils aus einem Anlagenbereich verwendet wird.

Wie in Fig. 38 schematisch dargestellt, soll ein Bauteil von einer Anfangsposition 35 in eine Endposition 36 verfahren werden.

Auf diesem Weg befinden sich die Hindernisse 37 und 38, an denen das Bauteil vorbeibewegt werden muss.

Zu erkennen ist, dass sich die Bewegung von der Anfangsposition 35 zur Endposition 36 aus zwei Linearbewegungen zusammensetzt, die im stumpfen Winkel zueinander verlaufen.

Die Darstellung bezieht sich auf eine Bewegung in einer Ebene, welche durch die horizontale und die vertikale Achse definiert ist, also eine vertikale Ebene. Zusätzlich dazu kann eine Kurve auch in der dritten Dimension, also der horizontalen Ebene durchgeführt werden, indem die Schwenkbewegung in die Bahnkurvensteuerung mit aufgenommen wird.

Eine Bewegungskurve setzt sich vorzugsweise aus zumindest zwei linearen Bewegungen zusammen.

Wie in Fig. 39 schematisch dargestellt, kann sich die Bewegung von einer Anfangsposition 35 zu einer Endposition 36 auch aus mehreren senkrecht zueinander verlaufenden Linearbewegungen zusammensetzen.

Es ist aber auch, wie dies in Fig. 40 dargestellt ist, bei einer Ausführungsform der Erfindung möglich, das von einer Anfangsposition 35 zunächst eine Drehbewegung oder eine Kreisbewegung ausgeführt wird und dass sodann in einer Linearbewegung das Bauteil zur Endposition 36 verfahren wird. Diese Drehbewegung oder Kreisbewegung kann beispielsweise durch kombinierte Linearbewegungen ausgeführt werden, um einem im Wesentlichen runden Hindernis 37 auszuweichen.

Die in den Zeichnungen Fig. 38 bis Fig. 40 dargestellte Bewegung in einer vertikalen Ebene, nämlich der x-z-Ebene lässt sich auch auf die anderen Raumrichtungen übertragen, insbesondere auf die horizontale Ebene, die x-y-Ebene.

In der horizontalen Ebene kann sich eine Linearbewegung teilweise aus der Schwenkbewegung des Arms und einer Linearbewegung des Verbindungsstücks der Serviceeinrichtung zusammensetzen.

Durch die Erfindung konnte ein leichtes und mobiles Hebezeug bereitgestellt werden, welches sich flexibel einsetzen lässt und welches sich auch zum Bewegen von schweren Lasten eignet.

### Bezugszeichenliste

- 1: Serviceeinrichtung
- 2: Träger
- 3: Arm
- 3a, 3b: Segment
- 4: Achse
- 5: Verbindungsstück
- 6: Trägeraufnahme
- 7: Armaufnahme
- 8: Gabel
- 8b: Oberteil
- 8a: Unterteil
- 9: Drehachse
- 10: Ausnehmung
- 11: Aufnahme
- 12-14: Pfeil
- 15: Drehachse
- 16: Anlage zur Prozessierung von Halbleiterbauelementen
- 17: Tisch
- 18: Schwingungsisolator
- 19: Stage
- 20: Rahmen
- 21: Metrology-Gerät
- 22: Sensor
- 23: Filterbaugruppe
- 24: Rollkoffer
- 25: Adapter
- 26: Hebel
- 27: Exzenter
- 28: Ausnehmung
- 29: Pfeil
- 30: Ausgleichsgelenk
- 31: Sensor
- 32: Verbindungsstück
- 33: Lesegerät
- 34: Speicher mit teaching-Daten
- 35: Anfangsposition
- 36: Endposition
- 37: Hindernis
- 38: Hindernis
- 39: Aktor

## Patentansprüche

1. Serviceeinrichtung (1) zum Anheben und Bewegen von Bauteilen einer Anlage (16) zur Prozessierung von Halbleiterbauelementen, wobei die Serviceeinrichtung ausgebildet ist, Gewichte von mindestens 5 kg zu bewegen, **gekennzeichnet durch** einen Träger (2), welcher zur Montage an einer Anlage zur Prozessierung von Halbleiterbauelementen ausgebildet ist, sowie einen Arm (3) mit einer Einrichtung zum Anheben eines Bauteils, wobei der Arm mittels eines Verbindungsstücks (5) in einer horizontalen Ebene schwenkbar am Träger angeordnet ist, wobei am schwenkbaren Arm (3) eine Lastaufnahme für ein Bauteil angeordnet ist, **dadurch gekennzeichnet, dass** das Verbindungsstück (5) entlang des Trägers (2) verfahrbar ist und wobei der Arm (3) quer zum Träger in einer vertikalen Richtung verfahrbar ist.

2. Serviceeinrichtung (1) nach dem vorstehenden Anspruch, **dadurch gekennzeichnet, dass** das Verbindungsstück (5) eine Armaufnahme (7) und eine Trägeraufnahme (6) aufweist, wobei die Armaufnahme (7) gegenüber der Trägeraufnahme (6) linear verfahrbar ist.

3. Serviceeinrichtung (1) nach einem der vorstehenden Ansprüche, **dadurch gekennzeichnet, dass** der Arm (3) und/oder die Lastaufnahme und/oder die Gabeln abnehmbar ausgebildet ist.

4. Serviceeinrichtung (1) nach einem der vorstehenden Ansprüche, **dadurch gekennzeichnet, dass** der Arm (3) über das Verbindungsstück (5) rotierbar ausgebildet ist.

5. Serviceeinrichtung (1) nach einem der vorstehenden Ansprüche, **dadurch gekennzeichnet, dass** die Lastaufnahme ausklappbare Gabeln (8) zur Aufnahme des Bauteils aufweist, insbesondere ausklappbaren Gabeln welche drehbar und/oder in einer horizontalen Richtung verschiebbar am Arm angeordnet sind.

6. Serviceeinrichtung (1) nach dem vorstehenden Anspruch, **dadurch gekennzeichnet, dass** der Arm (3) eine weitere Aufnahme (11) für ein Bauteil aufweist, welche vorzugsweise auf einer den Gabeln (8) gegenüberliegenden Seite des Arms (3) angeordnet ist.

7. Serviceeinrichtung (1) nach einem der vorstehenden Ansprüche, **dadurch gekennzeichnet, dass** die Serviceeinrichtung (1) zu einer mobilen Einheit zusammenklappbar ist und/oder mobil einsetzbar ausgebildet ist.

8. Serviceeinrichtung (1) nach einem der vorstehenden Ansprüche, **dadurch gekennzeichnet, dass** die Serviceeinrichtung schmiermittelfreie Gelenke, Schienen und/oder Lager, insbesondere Luftlager oder Magnetlager, aufweist, und/oder mit einer Partikelabsaugung ausgerüstet ist.

9. Anlage (16), insbesondere Anlage zur Prozessierung von Halbleiterbauelementen, umfassend eine Serviceeinrichtung (1) nach einem der vorstehenden Ansprüche, welche an der Anlage, insbesondere in einem Rahmen der Anlage, anbringbar ist.

10. Anlage (16) nach dem vorstehenden Anspruch, **dadurch gekennzeichnet, dass** die Anlage eine Aufnahme für einen Träger (2) der Serviceeinrichtung (1) aufweist.

11. Anlage (16) nach einem der beiden vorstehenden Ansprüche, **dadurch gekennzeichnet, dass** die Serviceeinrichtung (1) mit einem Schnellspannmechanismus an der Anlage (16) befestigbar ist, insbesondere wobei der Schnellspannmechanismus einen Adapter (25) aufweist, welcher vorzugsweise an einem Rahmen (20) der Anlage (16) angebracht ist.

12. Anlage (16) nach einem der vorstehenden Ansprüche, umfassend zwei sich gegenüberliegende Serviceeinrichtungen (1).

13. Verfahren zum Anheben und Bewegen eines Bauteils, wobei eine Serviceeinrichtung und/oder eine Anlage nach einem der vorstehenden Ansprüche verwendet wird.

14. Verfahren nach dem vorstehenden Anspruch, **dadurch gekennzeichnet, dass** mittels eines Controllers eine Bahnkurve mit zumindest zwei unterschiedlichen Bewegungsrichtungen abgefahren wird.

15. Verfahren nach einem der vorstehenden Ansprüche,
**dadurch gekennzeichnet, dass** mittels der Serviceeinrichtung zumindest zwei verschiedene Bauteile oder Anlagenteile angehoben und bewegt werden.

## Claims

1. A maintenance apparatus (1) for lifting and moving components of a system (16) for processing semiconductor devices, the maintenance apparatus being configured for lifting weights of at least 5 kg, **characterised by** a beam (2) that is configured for being mounted on a system for processing semiconductor devices, and an arm (3) with means for lifting a component, wherein the arm is mounted to the beam via a connecting piece (5) so as to be pivotable in a horizontal plane, wherein a load accommodation means for a component is provided on the pivotable arm (3); **characterised in that**
the connecting piece (5) is displaceable along the beam, and wherein the arm (3) is displaceable perpendicularly to the beam.

2. The maintenance apparatus (1) according to the preceding claim, **characterised in that** the connecting piece (5) has an arm seat (7) and a beam seat (6), wherein the arm seat (7) is displaceable translationally relative to the beam seat (6).

3. The maintenance apparatus (1) according to any one of the preceding claims, **characterised in that** the arm (3) and/or the load accommodation means and/or forks are configured so as to be detachable.

4. The maintenance apparatus (1) according to any one of the preceding claims, **characterised in that** the arm (3) is configured so as to be rotatable via the connecting piece (5).

5. The maintenance apparatus (1) according to any one of the preceding claims, **characterised in that** the load accommodation means comprises fold-out forks (8) for supporting the component, in particular fold-out forks which are mounted to the arm so as to be rotatable and/or displaceable in a horizontal direction.

6. The maintenance apparatus (1) according to the preceding claim, **characterised in that** the arm (3) comprises a further accommodation means (11) for a component, which is preferably arranged on a side of the arm (3) facing away from the forks (8).

7. The maintenance apparatus (1) according to any one of the preceding claims, **characterised in that** the maintenance apparatus (1) can be folded into a mobile unit and/or is suited for mobile use.

8. The maintenance apparatus (1) according to any one of the preceding claims, **characterised in that** the maintenance apparatus has lubricant-free joints, rails and/or bearings, in particular air bearings or magnetic bearings, and/or is equipped with a particle suction unit.

9. A system (16), in particular a system for processing semiconductor devices, comprising a maintenance apparatus (1) according to any one of the preceding claims, which can be mounted to the system, in particular to a frame of the system.

10. The system (16) according to the preceding claim, **characterised in that** the system has a seat for a beam (2) of the maintenance apparatus (1).

11. The system (16) according to any one of the two preceding claims, **characterised in that** the maintenance apparatus (1) can be mounted to the system (16) by means of a quick-connect clamping mechanism, wherein the quick-connect clamping mechanism in particular includes an adapter (25) which is preferably mounted to a frame (20) of the system (16).

12. The system (16) according to any one of the preceding claims, comprising two maintenance apparatuses (1) arranged opposite each other.

13. A method for lifting and moving a component, which comprises using a maintenance apparatus and/or a system according to any one of the preceding claims.

14. The method according to the preceding claim, **characterised in that** a controller is used for moving along a trajectory that includes at least two different movement directions.

15. The method according to any one of the preceding claims, **characterised in that** at least two different components or system parts are lifted and moved using the maintenance apparatus.

## Revendications

1. Dispositif de maintenance (1) destiné au levage et au déplacement d'éléments de construction d'une installation (16) de traitement de composants semi-conducteurs, le dispositif de maintenance étant conçu pour déplacer des poids d'au moins 5 kg, **caractérisé par** un support (2), qui est conçu pour le montage sur une installation de traitement de composants semi-conducteurs, ainsi qu'un bras (3) doté d'un dispositif de levage d'un élément de construction, le bras étant disposé sur le support avec possibilité de pivotement dans un plan horizontal, par l'intermédiaire d'une pièce d'assemblage (5), un moyen de support de charge pour un élément de construction étant disposé sur le bras (3) pivotant, **caractérisé en ce que** la pièce d'assemblage (5) peut être déplacée en translation le long du support (2), et le bras (3) pouvant être déplacé en translation perpendiculairement au support, dans une direction verticale.

2. Dispositif de maintenance (1) selon la revendication précédente, **caractérisé en ce que** la pièce d'assemblage (5) présente un élément recevant le bras (7) et un élément recevant le support (6), l'élément recevant le bras (7) pouvant être déplacé en translation linéaire par rapport à l'élément recevant le support (6).

3. Dispositif de maintenance (1) selon l'une des revendications précédentes, **caractérisé en ce que** le bras (3) et/ou le moyen de support de charge et/ou les fourches sont réalisés de manière amovible.

4. Dispositif de maintenance (1) selon l'une des revendications précédentes, **caractérisé en ce que** le bras (3) est réalisé avec possibilité de rotation, par l'intermédiaire de la pièce d'assemblage (5).

5. Dispositif de maintenance (1) selon l'une des revendications précédentes, **caractérisé en ce que** le moyen de support de charge présente des fourches (8) pouvant être dépliées en vue de prendre en charge l'élément de construction, notamment des fourches dépliables qui sont disposées avec possibilité de rotation et/ou avec possibilité de déplacement dans une direction horizontale.

6. Dispositif de maintenance (1) selon la revendication précédente, **caractérisé en ce que** le bras (3) présente un autre moyen de réception (11) pour un élément de construction, qui est de préférence disposé sur un côté du bras (3) qui est opposé aux fourches (8).

7. Dispositif de maintenance (1) selon l'une des revendications précédentes, **caractérisé en ce que** le dispositif de maintenance (1) peut être replié pour former une unité mobile et/ou est réalisé en vue d'une utilisation mobile.

8. Dispositif de maintenance (1) selon l'une des revendications précédentes, **caractérisé en ce que** le dispositif de maintenance présente des articulations, des glissières et/ou des paliers exempts de lubrifiant, en particulier des paliers à air ou des paliers magnétiques, et/ou est doté d'une aspiration de particules.

9. Installation (16), en particulier installation de traitement de composants semi-conducteurs, comprenant un dispositif de maintenance (1) selon l'une des revendications précédentes, qui peut être monté sur l'installation, notamment dans un cadre de l'installation.

10. Installation (16) selon la revendication précédente, **caractérisée en ce que** l'installation présente un moyen de réception pour un support (2) du dispositif de maintenance (1).

11. Installation (16) selon l'une des deux revendications précédentes, **caractérisée en ce que** le dispositif de maintenance (1) peut être fixé sur l'installation (16) à l'aide d'un mécanisme de serrage rapide, sachant notamment que le mécanisme de serrage rapide présente un adaptateur (25) qui est de préférence monté sur un cadre (20) de l'installation (16).

12. Installation (16) selon l'une des revendications précédentes, comprenant deux dispositifs de maintenance (1) se faisant face.

13. Procédé de levage et de déplacement d'un élément de construction, utilisant un dispositif de maintenance et/ou une installation selon l'une des revendications précédentes.

14. Procédé selon la revendication précédente, **caractérisé en ce qu'**une trajectoire est suivie à l'aide d'un contrôleur, avec au moins deux directions de déplacement différentes.

15. Procédé selon l'une des revendications précédentes, **caractérisé en ce qu'**au moins deux éléments de construction ou éléments de l'installation différents sont soulevés et déplacés à l'aide du dispositif de maintenance.
